# EUROPEAN PATENT APPLICATION

(11) **EP 1 282 252 A1**
(43) Date of publication of application: **05.02.2003**
(21) Application number: 01120814.7
(22) Date of filing: 29.08.2001
(51) Int. Cl.: H04J 14/02, H04B 10/155, H01S 5/024

(54) **OSP hardened WDM network**

(30) Priority: 03.08.2001 US 922001
(71) Applicant: Redfern Broadband Networks Inc., Wilmington, County of Newcastle, Delaware, 19801 (US)
(72) Inventor: Halgren, Ross, Collaroy Plateau, New South Wales 2097 (AU); Lauder, Richard, Maroubra, New South Wales 2035 (AU); Seiler, Chia, Bairnsdale, Victoria 3875 (AU)
(74) Representative: Schoppe, Fritz, Dipl.-Ing.

(57) **Abstract**

A WDM add/drop multiplexer structure comprising a plurality of WDM laser assemblies, wherein the WDM add/drop structure is arranged, in use, in a manner such that a controlled temperature environment is created around laser sources of the laser assemblies, and in a manner such as to be capable of creating the controlled temperature environment around the laser sources while the WDM add/drop multiplexer structure is subjected to an outside temperature ambient experienced in an Outside plant (OSP) situation.

## Description

### Field of the invention

The present invention relates broadly to a WDM add/drop multiplexer structure and to a laser assembly which may be used in a WDM add/drop multiplexer structure.

### Background of the invention

Optical networks may be classified into long haul optical networks, metro optical networks, access optical networks and enterprise gear-optical networks. Distinctions between the different types may in a first instance be drawn on the basis of physical transmission distances covered, decreasing from long haul optical networks down to enterprise gear-optical networks, with the latter being typically implemented within one location e.g. in one office building.

The different types of optical networks can also be distinguished in terms of the physical environment in which in particular add/drop equipment is located. For example, for enterprise gear-optical networks, the add/drop equipment is typically located inside of air conditioned buildings, and therefore no particular extreme temperature condition compliance is required to implement such optical networks. For long haul and metro optical networks, which typically involve very complex and expensive equipment, add/drop equipment is typically located in telecommunications carriers central offices and point of presence and are subjected to a limited range of temperatures, which is sometimes referred to as requiring the add/drop equipment to be carrier class compliant. This temperature range is typically in the range of 0-55°C as required for Telcordia NEBS level 3.

However, in access optical networks the add/drop equipment is typically located in an outside plant (OSP) situation, and thus potentially subjected to a wider temperature range than e.g. carrier class compliance requirements.

Currently, the only optical networks that can be implemented in scenarios where the required add/drop equipment is located in an OSP situation are Time Domain Multiplexing (TDM) based networks. So far, WDM based optical networks have not been deemed suitable for implementation in OSP situations, as currently available WDM equipment is not OSP compatible. However, it would be desirable to implement WDM based optical networks in such an environment, to utilise the larger capacity in the optical domain in access optical networks.

At least preferred embodiments of the present invention seek to provide a WDM add/drop multiplexer structure that is OSP compatible. In other preferred embodiments, the present invention seeks to provide a laser assembly which can be used in the design of a WDM add/drop multiplexer structure that is OSP compatible.

### Summary of the invention

In accordance with a first aspect of the present invention there is provided a WDM add/drop multiplexer structure comprising a plurality of WDM laser assemblies, wherein the WDM add/drop structure is arranged, in use, in a manner such that a controlled temperature environment is created around laser sources of the laser assemblies, and in a manner such as to be capable of creating the controlled temperature environment around the laser sources while the WDM add/drop multiplexer structure is subjected to an outside temperature ambient experienced in an OSP situation.

Preferably, the controlled temperature environment is defined by a low reference temperature value and a high reference temperature value.

The WDM add/drop multiplexer structure may comprise at least one further temperature sensitive device, and the WDM add/drop structure is arranged in a manner such that the controlled temperature environment is also created around the further temperature sensitive devices.

In one embodiment, the WDM add/drop structure comprises one or more housings in which the laser assemblies are located, and an active temperature controlling device arranged, in use, to heat an inside of the housings based on a measured temperature and a low temperature reference value.

The measured temperature may the actual temperature inside the housings. The measured temperature may be an ambient temperature around the housing. The ambient temperature may measured outside the WDM add/drop multiplexer structure.

The temperature controlling device may be further arranged, in use, to cool the housings based on the measured temperature and a high reference temperature value.

The housings advantageously comprise thermally insolated walls to reduce passive thermal load.

Heat generating components of the laser assemblies are preferably located outside of the housing, the WDM add/drop multiplexer structure being arranged, in use, in a manner which provides suitable connections between the heat generating components located outside the housing and laser sources of the laser assemblies located inside the housing.

In another embodiment, each laser assembly comprises:
- a semiconductor laser source,
- a heating unit for heating a junction of the semiconductor laser source,
- a cooling unit for cooling the junction, and
- a control unit for controlling operation of the heating and cooling units,
wherein the control unit is arranged, in use, to determine the actual temperature at the junction and to compare the actual temperature with a high reference temperature value and a low reference temperature value, and to selectively activate the heating and cooling units based on that comparison.

The control unit may be arranged to activate the heating unit when the actual temperature falls below the low reference temperature value, and to activate the cooling unit when the actual temperature increases above the high reference temperature value.

The laser assembly may further comprise a driver unit arranged, in use, to regulate a bias current of the semiconductor laser source to compensate for variations in a power output of the semiconductor laser source as a result of a tolerated temperature range of the controlled temperature environment.

Preferably, the driver unit is arranged, in use, to regulate the bias current based on the actual temperature at the junction determined by the control unit.

The driver unit may be arranged, in use, to regulate the bias current based on the actual power output of the semiconductor laser source. The driver unit may be further arranged, in use, to provide a modulation current to the semiconductor laser source.

The heating unit and cooling unit of each laser assembly may be implemented as a duel function heating/cooling unit. The duel function heating/cooling function comprises a TE device.

In both embodiments, the WDM add/drop multiplexer structure may comprise a plurality of WDM filters, and the high and low reference temperature values are chosen in a manner which ensures that, in use, wavelength drifts in the lasers are limited to a drift value equal to or less than a pass band of the WDM filters, whereby the wavelength drifts, in use, do not exceed a channel spacing of the WDM add/drop multiplexer structure.

The high reference temperature may be at least 70°C.

The low reference temperature may be 0°C or less.

In accordance with another aspect of the present invention there is provided a WDM add/drop multiplexer structure comprising a plurality of laser sources for providing optical WDM channel signals, wherein a wavelength spacing between the WDM channels is chosen in a manner which ensures that, in use, tolerated wavelength drifts of the laser sources as a result of tolerated temperature variations over substantially the operation temperature range of the laser sources are equal to or less than the wavelength spacing.

Preferably, the laser sources comprise un-cooled lasers.

The WDM add/drop multiplexer structure may be designed as a CWDM add/drop multiplexer structure.

In accordance with a third aspect of the present invention there is provided a laser assembly comprising:
- a semiconductor laser source,
- a heating unit for heating a junction of the laser source,
- a cooling unit for cooling the junction, and
- a control unit for controlling operation of the heating and cooling units,
wherein the control unit is arranged, in use, to determine the actual temperature at the junction and to compare the actual temperature with a high reference temperature value and a low reference temperature value, and to activate the heating and cooling units based on that comparison, a controlled temperature environment around the laser source created, and wherein the laser assembly is arranged, in use, in a manner such as to be capable of creating the controlled temperature environment while being subjected to an outside temperature ambient experienced in an OSP situation.

In accordance with a fourth aspect of the present invention there is provided a WDM network incorporating a WDM add/drop multiplexer structure as defined in the first aspect.

### Brief description of the drawings

Preferred forms of the present invention will now be described, by way of example only, with reference to the accompanying drawings.
Figure 1 shows a schematic diagram of a WDM add/drop multiplexer structure embodying the present invention.
Figure 2 shows a schematic diagram of a detail of Figure 1.
Figure 3 shows a schematic diagram of another WDM add/drop multiplexer structure embodying the present invention.
Figure 4 shows a schematic diagram of a detail of Figure 3.
Figure 5 shows a schematic diagram of another detail of Figure 3.
Figure 6 is a schematic drawing illustrating an optical communications network embodying the present invention.

### Detailed description of the embodiments

The preferred embodiments described provide a WDM add/drop multiplexer structure which is OSP compatible.

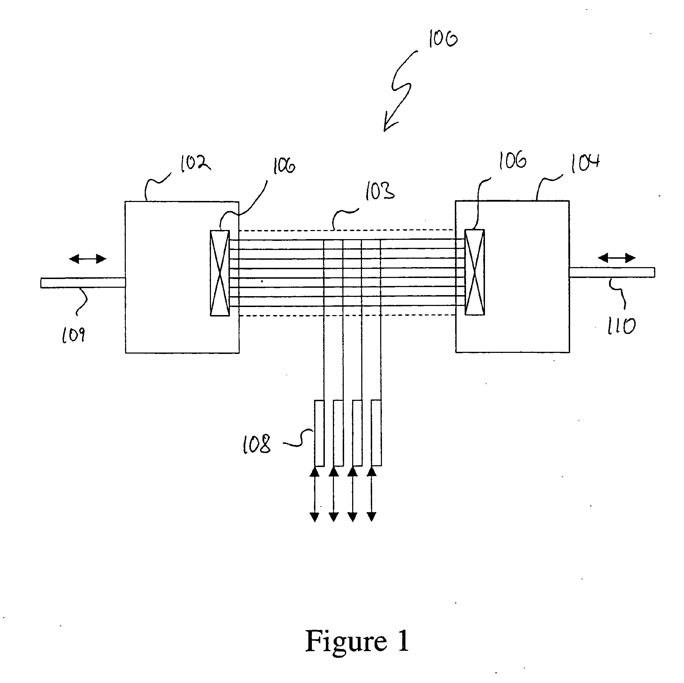

Figure 1 shows a schematic diagram of a WDM add/drop multiplexer structure 100 embodying the present invention. The structure 100 comprises two network interface modules 102, 104, an electrical connection backplane 103 and a plurality of tributary interface modules e.g. 108. The network interface modules 102, 104 incorporate electric cross-connect switches 106.

The network interface modules 102, 104 are connected to an optical network west trunk 109 and an optical network east trunk 110 respectively, of an optical network (not shown) to which the WDM add/drop multiplexer structure 100 is connected in-line.

In the WDM add/drop multiplexer structure 100, a controlled temperature environment for the WDM lasers is created by locating the WDM lasers within housings (not shown in Figure 1) incorporated of the network interface modules 102 and 104 respectively.

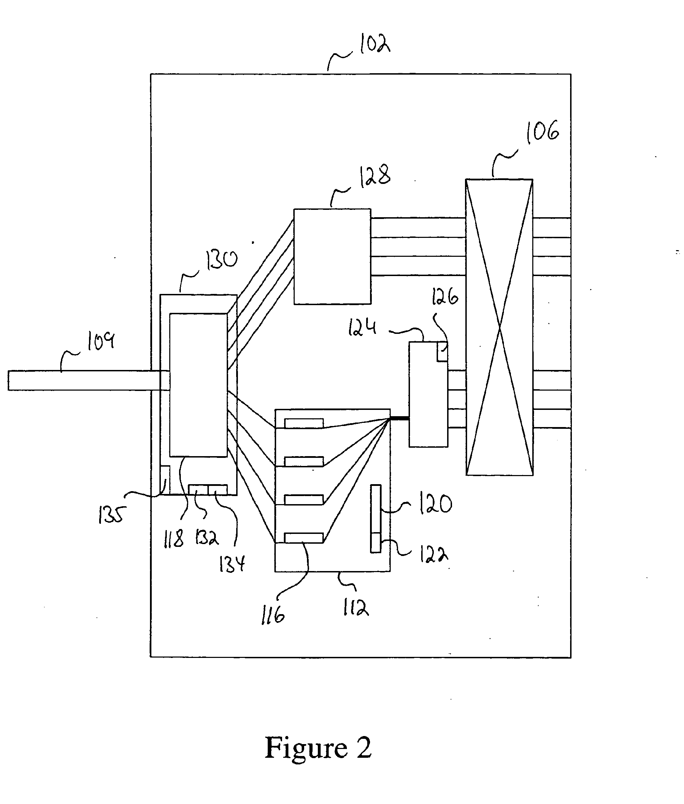

In Figure 2, details of the network interface modules e.g. 102 are shown. The network interface module 102 incorporates the housing 112 in which a plurality of laser sources e.g. 116 are mounted. The laser sources e.g. 116 are individually optically connected to a passive CWDM component 118 of the network interface module 102 for multiplexing the individual light signals into the optical network west trunk 109. A thermoelectric device 120 is also located in the housing 112 and incorporates a monitor unit 122 for monitoring the temperature inside the housing 112 and to activate the thermoelectric device 120 to increase the internal temperature through heating when the measured temperature falls below a low reference temperature value.

Similarly, if the measured temperature increasing above a high reference temperature value, the monitor unit 122 will activate the thermo-electric device 120 to decrease the internal temperature through cooling. In the embodiment shown in Figure 2, the housing 112 is formed from temperature insulating wall material to increase the cooling efficiency by reducing the passive thermal load.

In order to facilitate creation of a controlled local environment inside the housing 112, devices associated with the operation of the individual laser sources, e.g. 116, which generate significant heat are located outside the housing 112 in a chamber 124 incorporated in the network interface module 102. The chamber 124 has a ventilation fan 126.

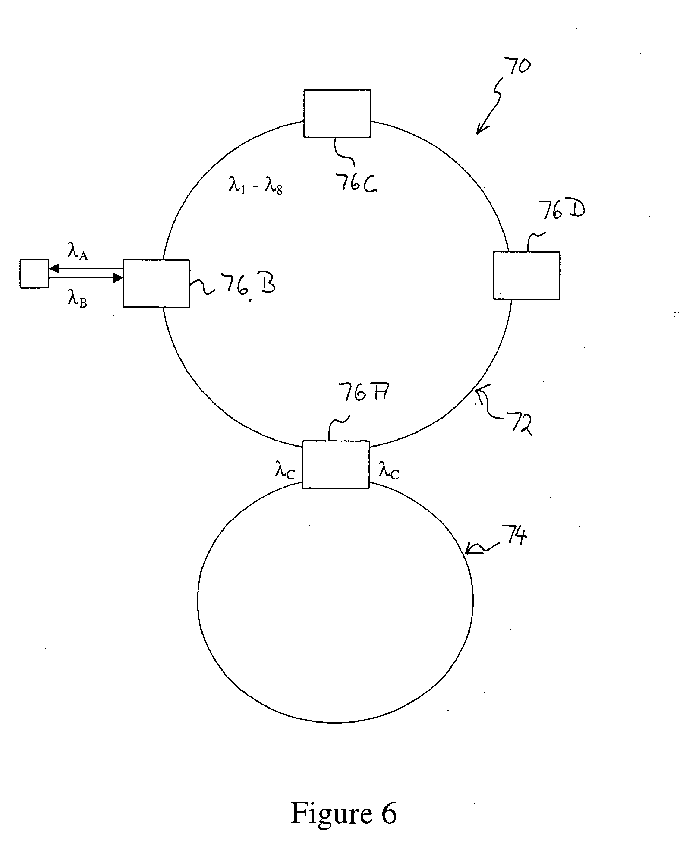

In the example embodiment shown in Figures 1 and 2, the low reference temperature value is chosen as 0°C, and the high reference temperature value as 70°C, thus giving an effective temperature range of -40°C to 85°C where the maximum ΔT_{H} of the thermoelectric device 120 is 40°C and the maximum ΔT_{C} = 15°C. This tolerated wavelength drift within the temperature range of 0-70°C is correlated with the selection of the pass bands of the passive CWDM component 118. The pass band for each wavelength is sufficiently large to accommodate this tolerate wavelength drift, making the WDM add/drop multiplexer structure 100 (Figure 6) OSP compatible.

In the optical network interface module 102, the passive CWDM component 118 is also located inside a housing 130. A thermo-electric device 132 and an associated monitor unit 134 are also located in the housing 130. The housing 180 is designed in a manner which provides thermal insulation from heat that may potentially be generated at varies components of the WDM add/drop multiplexer structure 100 (Figure 1) while providing a degree of ventilation through fan 135, i.e. fluid communication between the inside of the housing 130 and an external ambient around the WDM add/drop multiplexer structure 100 (Figure 1).

The monitor unit 134 monitors the temperature inside the housing 130 and activates the thermo-electric device 132 to increase the internal temperature through heating when the measured temperature falls below a low reference temperature value. Since the CWDM component 118 does not incorporate devices that generate a substantial amount of heat, the temperature inside the housing 130 will typically not increase above substantially the external ambient temperature around the WDM add/drop multiplexer structure 100 (Figure 1), provided sufficient thermal insulation from other heat generating components of the WDM add/drop multiplexer structure 100 (Figure 1) as mentioned above. Since the external ambient temperature under OSP conditions will typically never exceed 70°C, no cooling capacity needs to be provided inside the housing 130. In the example embodiment, the low reference temperature value for the housing 130 is also chosen as 0°C, which, in conjunction with a maximum ΔT_{H} of 40°C for the thermal electric device 132, extends the effective controlled operating range to -40°C external ambient temperature.

It is noted here that in different embodiments of the present invention, a "heat only" housing of the type of housing 130 for the CWDM component 118 may also be used for the laser sources, provided that it is taken into account that the heat generated inside such a laser housing during operation of the lasers will not exceed 70°C. In the embodiment described with reference to Figure 6 and 7, a somewhat safer design in relation to the high temperature end of the local environment around the laser sources e.g. 116 has been chosen by way of incorporating heating and cooling functionalities in the housing 112 as described above.

The optical network interface module 102 further comprises an optical/electrical converter unit 128 incorporating a 3R regeneration component (not shown) for each individual converted electrical channel signal.

In the WDM add/drop multiplexer structure 100, e.g. each wavelength channel signal received at the east network interface module 104 can either be dropped at the network node associated with the network node structure 100 via any one of the tributary interface modules e.g. 108, or alternatively can be through connected into the optical network west trunk 109 via the west network interface module 102.

Furthermore, it will also be appreciated by the person skilled in the art that the network node structure 100 is west-east/east-west traffic transparent. Also, due to the utilisation of network interface modules 102, 104 which each incorporate a 16 x 16 switch 106, a redundant switch is readily provided for the purpose of protecting the tributary interface cards e.g. 108 from a single point of failure. The tributary interface cards e.g. 108 are capable of selecting to transmit a signal to either (or both) network interface modules 102, 104 and the associated switches e.g 106. The function of the switches e.g. 106 is to select the wavelength that the optical signal received from the tributary interface cards e.g. 108 will be transmitted on, into the optical network.

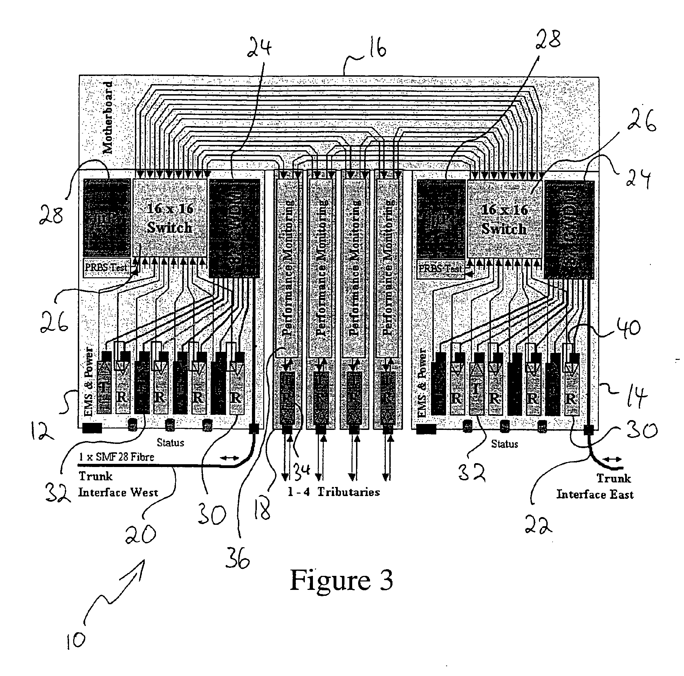

Figure 3 shows a schematic diagram of another WDM add/drop multiplexer structure 10 embodying the present invention. The structure 10 comprises two network interface modules 12, 14, an electrical connection backplane 16 and a plurality of tributary interface modules e.g. 18.

The network interface modules 12, 14 are connected to an optical network west trunk 20 and an optical network east trunk 22 respectively, of an optical network (not shown) to which the WDM add/drop multiplexer structure 10 is connected in-line.

Each of the network interface modules 12, 14 comprises the following components:
- a passive CWDM component 24, in the exemplary embodiment a 8 wavelength component;
- an electrical switch component, in the exemplary embodiment a 16 x 16 switch 26;
- a microprocessor 28;
- a plurality of receiver trunk interface modules e.g. 30; and
- a plurality of transmitter trunk interface modules e.g. 32, and
- a plurality of electrical regeneration unit e.g. 40 associated with each receiver trunk interface card e.g. 30.

In the exemplary embodiment, each regeneration unit e.g. 40 performs 3R regeneration on the electrical channels signal converted from a corresponding optical WDM channel signal received at the respective receiver trunk interface module e.g. 30. Accordingly, the network node structure 10 can provide signal regeneration capability for each channel signal combined with an electrical switching capability for add/drop functionality.

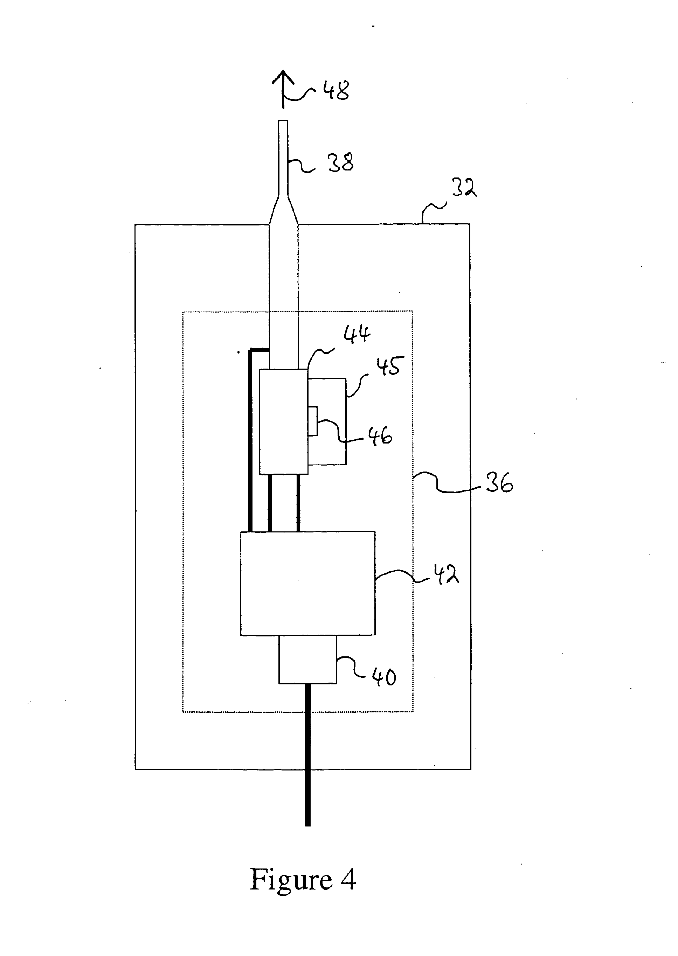

Details of the transmitter trunk interface modules e.g. 32 will now be described with reference to Figure 4.

In Figure 4, the transmitter trunk interface modules 32 incorporates a laser assembly 36. An electrical signal received from the switch 26 (Figure 3) is converted into an optical signal emitted from the laser assembly 36 for transmission along an optical fibre connection 38 to the passive CWDM component 24 (Figure 3).

The laser assembly 36 comprises an electrical receiver component 40 connected to a driver 42 of the laser assembly 36. The laser assembly 36 further comprises a semi conductor laser source 44 and a temperature control circuit 45 incorporating a TE device 46 directly mounted onto the laser source 44.

The temperature control circuit 45 is adapted to determine the junction temperature of the laser source 44 and to compare the actual junction temperature with a high temperature reference value and a low temperature reference value. It is noted that in the preferred embodiment the laser source 44 is arranged in a manner such that the actual junction temperature can be determined by direct measurement. However, it will be appreciated by a person skilled in the art that in other embodiments, where direct measurement of the junction temperature is not possible, the actual junction temperature can be derived from other temperature measurements, e.g. measurement of the ambient temperature immediately adjacent the laser source, through suitable calibration processing. If the actual junction temperature exceeds the high temperature reference value, the control circuit 45 applies a positive voltage to the TE device 46 to cool the laser source 44, specifically the active junction of the laser source 44, to maintain the actual junction temperature at the high reference temperature value. Similarly, if the actual junction temperature falls below the low temperature reference value, the control circuit 45 applies a negative voltage to the TE device 46 to heat the laser source 44.

In the preferred embodiment, the TE device 46 is characterised by a maximum ΔT_{H} = 40°C for heating, and a maximum ΔT_{C} = 15°C for cooling. In other words, the TE device 46 is capable of maintaining the junction temperature at the high reference temperature value in an ambient temperature of up to 15°C above the high reference temperature value, and capable of maintaining the junction temperature at the low reference temperature value in an ambient temperature of up to 40°C below the low reference temperature value.

It will be appreciated by the person skilled in the art that accordingly the optical output from the laser assembly 36 has a tolerated wavelength drift depending on the temperature range defined by the high and low reference temperature values.

In the example embodiment, the high reference temperature value is chosen to be 70°C, whereas the low reference temperature value is chosen to 0°C. In the example embodiment, the optical output of the laser assembly 36 thus experiences a wavelength drift of approximately 6.5nm over the full tolerated temperature range.

In the design of the WDM add/drop multiplexer structure 10 (Figure 3) embodying the present invention, this tolerated wavelength drift is correlated with the selection of a wavelength spacing in the WDM channels of the WDM add/drop multiplexer structure 10. The passive CWDM component 24 (Figure 1) has a pass-band for each wavelength that is sufficiently large to accommodate the tolerated temperature range, thus making the WDM add/drop multiplexer structure 10 (Figure 1) OSP compatible. In the example embodiment, the theoretical operating range will be from -40°C to 85°C.

Returning to Figure 4, since the semiconductor laser source 44 in the preferred embodiment experiences a tolerated, significant temperature variation i.e. from 0-70°C, the bias current needs to be regulated by the driver 42 to compensate for drift in the power output of the semiconductor laser source 44. The driver 42 monitors the output power of the laser source 44 and adjusts the bias current accordingly. At the same time, the driver 42 also provides modulation current to the laser source 44 for conversion of the electrical signal received at the transmitter trunk interface card 32 into an optical signal 48 for transmission along the optical network.

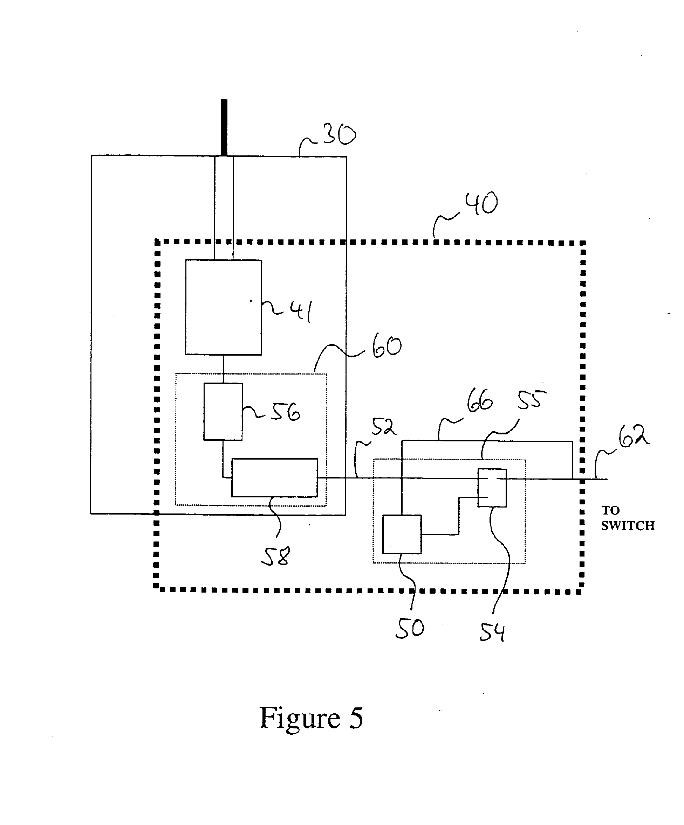

Details of the receiver trunk interface cards e.g. 30 (Figure 1) and regeneration unit e.g. 40 (Figure 1) of the WDM add/drop multiplexer structure 10 (Figure 1), will now be described with reference to Figure 5.

In Figure 5, the regeneration component 40 comprises a linear optical receiver 41 of the receiver trunk interface card 30. The linear optical receiver comprises a transimpendence amplifier (not shown) i.e. 1R regeneration is performed on the electrical receiver signal within the linear optical receiver 41.

The regeneration unit 40 further comprises an AC coupler 56 and a binary detector component 58 formed on the receiver trunk interface card 30. Together the AC coupler 56 and the binary detector 58 form a 2R regeneration section 60 of the regeneration unit 40.

The regeneration unit 40 further comprises a programmable phase lock loop (PLL) 50 tapped to an electrical input line 52 and connected to a flip flop 54. The programmable PLL 50 and the flip flop 54 form a programmable clock data recovery (CDR) section 55 of the regeneration unit 40.

It will be appreciated by a person skilled in the art that at the output 62 of the CDR section 55 the electrical receiver signal (converted from the received optical CWDM channel signal over optical fibre input 64) is 3R regenerated at the network node structure. It is noted that in the exemplary embodiment shown in Figure 5, a 2R bypass connection 66 is provided, to bypass the CDR section 55 if desired.

Returning now to Figure 3, each of the tributary interface modules e.g. 18 comprises a tributary transceiver interface card 34 and an electrical performance monitoring unit 36. In the exemplary embodiment, a 3R regeneration unit (not shown) similar to the one described in relation to the receiver trunk interface cards e.g. 30 with reference to Figure 2 is provided. Accordingly, 3R regeneration is conducted on each received electrical signal converted from received optical input signals prior to the 16 x 16 switch 26.

As can be seen from the connectivity provided through the electrical backplane 16, each of the electrical switches 26 facilitates that any trunk interface card e.g. 30, 32 or tributary interface card e.g. 18 can be connected to any trunk interface card e.g. 30, 32, or tributary interface card e.g. 18. Accordingly, e.g. each wavelength channel signal received at the east network interface module 14, e.g. at receiver trunk interface card 38 can either be dropped at the network node associated with the network node structure 10 via any one of the tributary interface modules e.g. 18, or alternatively can be through connected into the optical network west trunk 20 via the west network interface module 12.

Furthermore, it will also be appreciated by the person skilled in the art that the network node structure 10 is west-east/east-west traffic transparent. Also, due to the utilisation of network interface modules 12, 14 which each incorporate a 16 x 16 switch 26, a redundant switch is readily provided for the purpose of protecting the tributary interface cards e.g. 18 from a single point of failure. The tributary interface cards e.g. 18 are capable of selecting to transmit a signal to either (or both) network interface modules 12, 14 and the associated switches e.g 26. The function of the switches e.g. 26 is to select the wavelength that the optical signal received from the tributary interface cards e.g. 18 will be transmitted on, into the optical network.

Figure 6 shows an exemplary optical communications network 70 comprising an access ring network 72 and a sub-ring network 74. The access ring network 72 comprises a plurality of network nodes 76, each incorporating a WDM add/drop multiplexer structure of the type of WDM add/drop multiplexer structures 10 or 100 described above with reference to Figures 1 to 7. Significantly, in the exemplary optical communications network 70 the network nodes 76 are physically located in an OSP situation, i.e. they are subjected to potential large temperature variations which may typically be between -40°C and +65°C.

The sub-network 74 can comprise a single wavelength SONET based network, with one of the 8 available wavelengths in the example embodiment being dropped and re-added at the network node 76A. In the example embodiment, the wavelength utilised in the sub-ring network 74 is denoted λ_{C}. Importantly, this wavelength may be different to any one of the wavelength λ₁-λ₈ and the associated tributary interface card (not shown) is configured accordingly. An example wavelength utilised in the sub-ring network 74 may be 1310nm, whereas the wavelength chosen in the access ring 72 may be:
λ₁=1470nm
λ₂=1490nm
λ₃=1510nm
λ₄=1530nm
λ₅=1550nm
λ₆=1570nm
λ₇=1590nm
λ₈=1610nm

At the other network nodes 76, e.g. at network node 76B, other wavelengths are dropped and added to individual subscriber connections, e.g. at network node 76B. Again, the tributary interface cards (not shown) may add/drop the signals at different wavelengths than the ones used within the access ring network 72, in the exemplary embodiment denoted λ_{A} and λ_{B}.

In the exemplary embodiment shown in Figure 6, the access ring network 72 is configured as a CWDM network having eight channels i.e. relatively widely spaced wavelength signals which reduces the likelihood of cross talk between channels, thus enabling less stringent design parameters in the implementation of the network. Furthermore, this also reduces the possibility of adjacent channel cross talk due to temperature related wavelength drift, thus permitting the application of the invention to outside enclosures that are subjected to wide temperature variations.

As a result of utilising electrical regeneration of the CWDM channel signals at each network node 76, no costly optical amplification units need to be provided in a typical access network environment, i.e. typical transmission distance between network nodes of the order of 20km. Thus, the exemplary embodiment can be implemented as a cost effective upgrade of an existing SONET based and/or SONET/TDM based optical network to form the access ring network 72.

At each of the network nodes 76, any of the four channels (i.e. four pairs of wavelengths travelling in opposite directions around the ring network 72, e.g. λ₁, λ₂) can be dropped from/added into the access ring network 72. Due to the west-east/east-west transparency of each of the network nodes 76, communications between individual network nodes may be transmitted along different directions around the access ring network 72 to effect path protection. The channel allocation scheme must merely account for the fact that each channel can only be utilised once between the individual network nodes 76 should a single fibre bidirectional connection be used between the nodes 76 as in the example embodiment shown in Figure 6. However, it is noted that due to the selective switching configuration of the network nodes 76 channels may be switched at individual network nodes 76 to maximise the overall bandwidth usage between the individual network elements 76 and ultimately in the overall access ring network 72.

It is noted that the present invention may also be implemented with two or more fibre connections between network nodes, in which case the wavelength resources between the network nodes is increased. The channel allocation scheme in such embodiments can be expanded accordingly.

One of the applications/advantages of embodiments of the present invention is that the electronic switches support broadcast and multicast transmissions of the same signal over multiple wavelengths. This can have useful applications in entertainment video or data casting implementation. Many optical add/drop solutions do not support this feature, instead, they only support logical point-point connections since the signal is dropped at the destination node and does not continue to the next node.

It will be appreciated by the person skilled in the art that numerous modifications and/or variations may be made to the present invention as shown in the specific embodiments without departing from the spirit or scope of the invention as broadly described. The present embodiments are, therefore, to be considered in all respects to be illustrative and not restrictive.

In the claims that follow and in the summary of the invention, except where the context requires otherwise due to express language or necessary implication the word "comprising" is used in the sense of "including", i.e. the features specified may be associated with further features in various embodiments of the invention.

## Claims

1. A WDM add/drop multiplexer structure comprising a plurality of WDM laser assemblies, wherein the WDM add/drop structure is arranged, in use, in a manner such that a controlled temperature environment is created around laser sources of the laser assemblies, and in a manner such as to be capable of creating the controlled temperature environment around the laser sources while the WDM add/drop multiplexer structure is subjected to an outside temperature ambient experienced in an Outside plant (OSP) situation.

2. A WDM add/drop multiplexer structure as claimed in claim 1, wherein the controlled temperature environment is defined by a low reference temperature value and a high reference temperature value.

3. A WDM add/drop multiplexer structure as claimed in claims 1 or 2, wherein the WDM add/drop multiplexer structure comprises at least one further temperature sensitive device, and the WDM add/drop structure is arranged in a manner such that the controlled temperature environment is also created around the further temperature sensitive devices.

4. A WDM add/drop multiplexer structure as claimed in any one of the preceding claims, wherein the WDM add/drop structure comprises one or more housings in which the laser assemblies are located, and an active temperature controlling device arranged, in use, to heat an inside of the housings based on a measured temperature and a low temperature reference value.

5. A WDM add/drop multiplexer structure as claimed in claim 4, wherein the measured temperature is the actual temperature inside the housings.

6. A WDM add/drop multiplexer structure as claimed in claim 4, wherein the measured temperature is an ambient temperature around the housing.

7. A WDM add/drop multiplexer structure as claimed in claim 6, wherein the ambient temperature is measured outside the WDM add/drop multiplexer structure.

8. A WDM add/drop multiplexer structure as claimed in any one of claims 4 to 7, wherein the temperature controlling device is further arranged, in use, to cool the housings based on the measured temperature and a high reference temperature value.

9. A WDM add/drop multiplexer structure as claimed in claim 8, wherein the housings comprise thermally insolated walls to reduce passive thermal load.

10. A WDM add/drop multiplexer structure as claimed in any one of claims 4 to 9, wherein heat generating components of the laser assemblies are located outside of the housing, the WDM add/drop multiplexer structure being arranged, in use, in a manner which provides suitable connections between the heat generating components located outside the housing and laser sources of the laser assemblies located inside the housing.

11. A WDM add/drop multiplexer structure as claimed in any one of claims 1 to 3, wherein each laser assembly comprises:
- a semiconductor laser source,
- a heating unit for heating a junction of the semiconductor laser source,
- a cooling unit for cooling the junction, and
- a control unit for controlling operation of the heating and cooling units,
wherein the control unit is arranged, in use, to determine the actual temperature at the junction and to compare the actual temperature with a high reference temperature value and a low reference temperature value, and to selectively activate the heating and cooling units based on that comparison.

12. A WDM add/drop multiplexer structure as claimed in claim 11, wherein the control unit is arranged to activate the heating unit when the actual temperature falls below the low reference temperature value, and to activate the cooling unit when the actual temperature increases above the high reference temperature value.

13. A WDM add/drop multiplexer structure as claimed in claims 11 or 12, wherein the laser assembly further comprises a driver unit arranged, in use, to regulate a bias current of the semiconductor laser source to compensate for variations in a power output of the semiconductor laser source as a result of a tolerated temperature range of the controlled temperature environment.

14. A WDM add/drop multiplexer structure as claimed in claim 13, wherein the driver unit is arranged, in use, to regulate the bias current based on the actual temperature at the junction determined by the control unit.

15. A WDM add/drop multiplexer structure as claimed in claim 13, wherein the driver unit is arranged, in use, to regulate the bias current based on the actual power output of the semiconductor laser source.

16. A WDM add/drop multiplexer structure as claimed in claim 13, wherein the driver unit is further arranged, in use, to provide a modulation current to the semiconductor laser source.

17. A WDM add/drop multiplexer structure as claimed in any one of claims 11 to 16, wherein the heating unit and cooling unit of each laser assembly are implemented as a duel function heating/cooling unit.

18. A WDM add/drop multiplexer structure as claimed in any one of claims 11 to 17, wherein the duel function heating/cooling function comprises a TE device.

19. A WDM add/drop multiplexer structure as claimed in claim 2, wherein the WDM add/drop multiplexer structure comprises a plurality of WDM filters, and the high and low reference temperature values are chosen in a manner which ensures that, in use, wavelength drifts in the lasers are limited to a drift value equal to or less than a pass band of the WDM filters, whereby the wavelength drifts, in use, do not exceed a channel spacing of the WDM add/drop multiplexer structure.

20. A WDM add/drop multiplexer structure as claimed in claim 2, wherein the high reference temperature is at least 70°C.

21. A WDM add/drop multiplexer structure as claimed in claim 2, wherein the low reference temperature is 0°C or less.

22. A WDM add/drop multiplexer structure comprising a plurality of laser sources for providing optical WDM channel signals, wherein a wavelength spacing between the WDM channels is chosen in a manner which ensures that, in use, tolerated wavelength drifts of the laser sources as a result of tolerated temperature variations are equal to or less than the wavelength spacing.

23. A WDM add/drop multiplexer structure as claimed in claim 22, the laser sources comprise un-cooled lasers.

24. A WDM add/drop multiplexer structure as claimed in claims 22 or 23, wherein the WDM add/drop multiplexer structure is designed as a CWDM add/drop multiplexer structure.

25. A laser assembly comprising:
- a semiconductor laser source,
- a heating unit for heating a junction of the laser source,
- a cooling unit for cooling the junction, and
- a control unit for controlling operation of the heating and cooling units,
wherein the control unit is arranged, in use, to determine the actual temperature at the junction and to compare the actual temperature with a high reference temperature value and a low reference temperature value, and to activate the heating and cooling units based on that comparison, a controlled temperature environment around the laser source created, and wherein the laser assembly is arranged, in use, in a manner such as to be capable of creating the controlled temperature environment while being subjected to an outside temperature ambient experienced in an OSP situation.

26. An WDM network incorporating a WDM add/drop multiplexer structure as claimed in any one of the preceding claims.
